# EUROPEAN PATENT APPLICATION

(11) **EP 4 629 293 A1**
(43) Date of publication of application: **08.10.2025**
(21) Application number: 23914581.6
(22) Date of filing: 28.12.2023
(51) Int. Cl.: H01L 27/085

(54) **GALLIUM NITRIDE DEVICE AND MANUFACTURING METHOD FOR GALLIUM NITRIDE DEVICE**

(30) Priority: 04.01.2023 CN 202310007621; 04.01.2023 CN 202311138815
(71) Applicant: ZTE CORPORATION, Shenzhen, Guangdong 518057 (CN)
(72) Inventor: WU, Sheng, Shenzhen, Guangdong 518057 (CN); LIU, Haijun, Shenzhen, Guangdong 518057 (CN); ZHANG, Yu, Shenzhen, Guangdong 518057 (CN); LI, Wenming, Shenzhen, Guangdong 518057 (CN); DAI, Yunfei, Shenzhen, Guangdong 518057 (CN)
(74) Representative: Perronace, Andrea
(86) International application number: PCT/CN2023/142945
(87) International publication number: WO 2024/146449

(57) **Abstract**

Provided in the embodiments of the present disclosure are a gallium nitride device and a manufacturing method for the gallium nitride device. The gallium nitride device includes: at least two combination layers, wherein a gate electrode is provided on the uppermost combination layer, a plurality of gate recesses with different depths are formed below the gate electrode, and the gate recesses are filled with P-type gallium nitride.

## Description

### Cross-Reference to Related Application

The present disclosure is based on Chinese patent application CN 202310007621.1 filed on 04 January 2023 and entitled "Gallium Nitride Device and Manufacturing Method for Gallium Nitride Device", and Chinese patent application CN 202311138815.1 filed on 01 September 2023 and entitled "Gallium Nitride Device and Manufacturing Method for Gallium Nitride Device", and claims priority to the patent applications, the disclosure of which is incorporated herein by reference in its entirety.

### Technical Field

The embodiments of the present disclosure relate to the field of communication technology and semiconductor manufacturing, and in particular, to a gallium nitride device and a manufacturing method for the gallium nitride device.

### Background

In the academic community, researchers always modulate the relationship between the carrier velocity and the elecric-field, and the gate-source capacitance under the gate of device for a linearity enhanced GaN HEMT. Specific technical solutions encompass: employing an increased barrier layer thickness, adjusting the electric field in the channel of gate to drain through the utilization of a field plate structure, incorporating a graded aluminum composition barrier, adopting a Metal Insulator Semiconductor (MIS) configuration, utilizing a dual-channel material to enhance the limitation of 2-dimensional electron gas (2DEG) density, implementing a Fin-HEMT featuring a three-dimensional fin architecture, and introducing a trancitional recessed gate structure based on threshold coupling, among others. However, in the context of high-frequency communication systems, these technical solutions possess more or less inherent and critical flaws. For examples, a greater barrier thickness will introduce a stronger drain-induced barrier lowering effect, limiting the use of the device at high frequencies; the field plate structure tends to introduce excessive parasitic capacitance in high-frequency schemes, limiting the high-frequency performance of the device; the growth of the graded aluminum composition material is extremely challenging, making it difficult to achieve large-scale production with low costs and high-uniformity; the MIS structure introduces new parasitics, affecting the stability of the device; the Fin-HEMT having a three-dimensional fin structure introduces parasitic capacitance by sacrificing the device output capability, limiting the frequency performance; the progressively recessed gate technology is difficult to implement, and has high requirements on lithography and etching techniques, making it difficult to apply on a large scale, etc.

So far, no solution has been proposed for the problems in the prior art of introduction of parasitic capacitance limiting the frequency performance, great difficulties in implementation and difficulties in large-scale application.

### Summary

The embodiments of the present disclosure provide a gallium nitride device and a method for manufacturing the gallium nitride device, so as to solve the problems in the related art of introduction of parasitic capacitance limiting the frequency performance, great difficulties in implementation and difficulties in large-scale application.

According to an embodiment of the present disclosure, provided is a gallium nitride device. The gallium nitride device includes: at least two combination layers, wherein a gate electrode is arranged on the uppermost combination layer; and a plurality of gate recesses having different depths are provided below the gate electrode, and the gate recesses are filled with P-type gallium nitride.

According to another embodiment of the present disclosure, further provided is a method for manufacturing a gallium nitride device. The method includes: acquiring an epitaxial substrate including at least two combination layers; etching to fabricate a plurality of gate recesses having at least two depths in the at least two combination layers, and filling the gate recesses with P-type gallium nitride; and fabricating a gate electrode on the uppermost combination layer.

### Brief Description of the Drawings

Fig. 1 is a schematic structural diagram of a gallium nitride device according to an embodiment of the present disclosure;
Fig. 2 is a flowchart of a method for manufacturing a gallium nitride device according to an embodiment of the present disclosure;
Fig. 3 is a schematic structural diagram of a gallium nitride high linearity device with channel composite modulation based on P-N junction depletion capacitance according to an embodiment of the present disclosure;
Fig. 4 is a structural exploded view of a gallium nitride high linearity device with channel composite modulation based on P-N junction depletion capacitance according to an embodiment of the present disclosure;
Fig. 5 is a device-level structural exploded view of a gallium nitride high linearity device with channel composite modulation based on P-N junction depletion capacitance according to an embodiment of the present disclosure;
Fig. 6 is a cross-sectional view of a GaN high linearity device with channel composite modulation based on P-N junction depletion capacitance corresponding to a five-channel material according to an embodiment of the present disclosure;
Fig. 7 is a schematic diagram of a process for fabricating a GaN high linearity device with channel composite modulation based on P-N junction depletion capacitance according to an embodiment of the present disclosure.

### Detailed Description of the Embodiments

The embodiments of the present disclosure will be described below in detail with reference to the drawings and in conjunction with the embodiments.

It should be noted that, terms such as "first" and "second" in the description and the claims of the present disclosure and the drawings are used to distinguish similar objects, but are not necessarily used to describe a specific sequence or order.

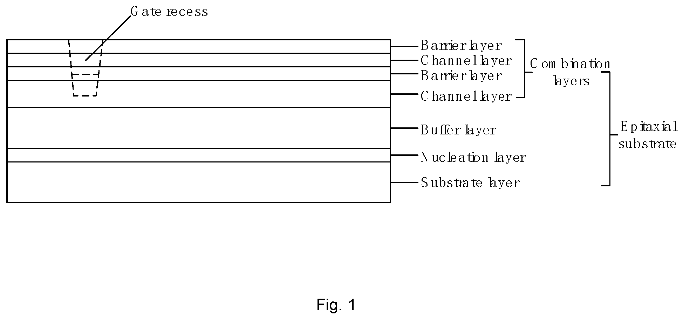

Provided in the present embodiment is a gallium nitride device. The gallium nitride device has high linearity characteristics, and the linearity of the gallium nitride device can be determined by: measuring a 3rd-order Inter Modulation Distortion (IMD3), inputting two radio frequency signals with similar frequencies into a gate electrode, with a drain electrode biased at a target potential, monitoring two output target channel signals and multiple intermodulation signals from the drain electrode, and subtracting the target channel power from the intermodulation signal power to obtain IMD3. Taking an application channel at 3.6 Hz as an example, equal-amplitude signals at 3.6 Hz and 3.61 Hz are input to the gate electrode, and IMD3 is obtained by subtracting the power of the signal at 3.6 Hz (or 3.61 Hz) from the power of the signal at 3.59 Hz (or 3.62 Hz) monitored at the drain electrode. The value is below -25 dBc, which indicates that the device satisfies the requirement for high linearity. By varying the input power and measuring the power curves on the basis of the measurement method, the intersection between lines extended from a target channel power curve and a third-order intermodulation distortion curve is obtained, which is referred to as a 3rd-order Intercept Point (IP3). The corresponding input power is an Input 3rd-order Intercept Point (IIP3), and the corresponding output power is an Output 3rd-order Intercept Point (OIP3). Higher values of these two powers indicate better linearity of the device. Fig. 1 is a schematic structural diagram of a gallium nitride device according to an embodiment of the present disclosure. As shown in Fig. 1, the gallium nitride device includes: an epitaxial substrate, the epitaxial substrate including a substrate layer, a nucleation layer, a buffer layer and combination layers which are connected from bottom to top, wherein there are at least two combination layers, each combination layer includes a channel layer and a barrier layer which are connected from bottom to top, and a gate electrode, a source electrode and a drain electrode are arranged on the uppermost barrier layer; and gate recesses which are periodically distributed and mutually spaced at different depths are provided below the gate electrode, P-type gallium nitride having a pre-determined thickness is filled in the gate recesses by means of a dielectric mask growth technology, and the P-type gallium nitride is used for depleting the two-dimensional electron gas at an interface between the barrier layer and the channel layer in each combination layer corresponding to the gate recesses.

The number of the combination layers in the present embodiment may be two or more. When there are two combination layers, the epitaxial substrate includes a substrate layer, a nucleation layer, a buffer layer, a channel layer 2, a barrier layer 2, a channel layer 1 and a barrier layer 1 which are connected from bottom to top, wherein a gate electrode, a source electrode and a drain electrode are arranged above the barrier layer 1.

In an embodiment, in the case that the combination layers include a first combination layer (the channel layer 1 and the barrier layer 1) and a second combination layer (the channel layer 2 and the barrier layer 2), the gate recesses include first-type recesses and second-type recesses, the first-type recesses extend into the channel layer (i.e. the channel layer 1) of the first combination layer or into the barrier layer (i.e. the barrier layer 2) of the second combination layer, and the second-type recesses extend into the channel layer (i.e. the channel layer 2) of the second combination layer or into the buffer layer, wherein the first-type recesses are used for cutting off a two-dimensional electron gas at an interface between the barrier layer (i.e. the barrier layer 1) and the channel layer (i.e. the channel layer 1) in the first combination layer; and the second-type recesses are used for cutting off a two-dimensional electron gas at an interface between the barrier layer (the barrier layer 1) and the channel layer (i.e. the channel layer 1) in the first combination layer, and an interface between the barrier layer (i.e. the barrier layer 2) and the channel layer (i.e. the channel layer 2) in the second combination layer.

In an embodiment, each first-type recess and the second-type recess adjacent thereto form a nano-channel restriction for a first layer of two-dimensional electron gas at the interface between the barrier layer (i.e. the barrier layer 1) and the channel layer (i.e. the channel layer 1) in the first combination layer; and the second-type recesses which are adjacent to each other form a nano-channel restriction for a second layer of two-dimensional electron gas at the interface between the barrier layer (the barrier layer 2) and the channel layer (i.e. the channel layer 2) in the second combination layer.

In the present embodiment, the number of gate recess types is the same as that of the combination layers, and the depths of the gate recesses range from 40 nm to 240 nm.

In the present embodiment, a P-N junction is formed on the basis of P-type GaN, the depletion capacitance generated thereby depletes the two-dimensional electron gas near the side walls of the device channel, thereby forming two mutually coupled nano-channels in a dual-channel material, enhancing the linearity characteristics of the GaN device to achieve high linearity characteristics of the gallium nitride device. Moreover, in the present embodiment, the nano-channels of each layer are arranged in a spatially dispersed manner by means of different recesses arranged periodically, thereby relieving the heat dissipation pressure of the device.

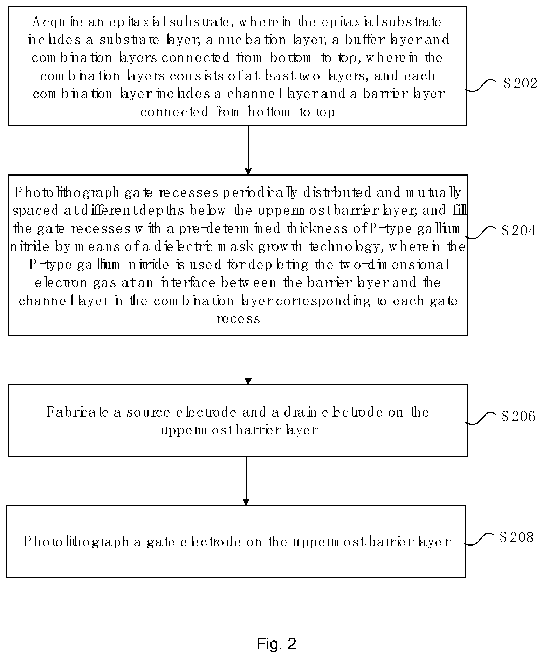

Fig. 2 is a flowchart of a method for manufacturing a gallium nitride device according to an embodiment of the present disclosure. As shown in Fig. 2, the flow includes the following steps:
step S202: acquire an epitaxial substrate, wherein the epitaxial substrate includes a substrate layer, a nucleation layer, a buffer layer and combination layers which are connected from bottom to top, wherein there are at least two combination layers, and each combination layer includes a channel layer and a barrier layer which are connected from bottom to top;
step S204: photolithograph gate recesses which are periodically distributed and mutually spaced at different depths below the uppermost barrier layer, and fill the gate recesses with a pre-determined thickness of P-type gallium nitride by means of a dielectric mask growth technology, wherein the P-type gallium nitride is used for depleting the two-dimensional electron gas at an interface between the barrier layer and the channel layer in the combination layer corresponding to each gate recess; and
step S206: fabricate a source electrode and a drain electrode on the uppermost barrier layer.

In the present embodiment, step S206 may specifically include: spin coat photoresist on the surface of the epitaxial substrate, photolithograph a source electrode pattern and a drain electrode pattern, and perform a predetermined dose of silicon ion implantation into the source electrode pattern and the drain electrode pattern by means of an ion implantation process; and spin coat the photoresist on the surface of the epitaxial substrate, photolithograph the source electrode pattern and the drain electrode pattern again, etch the silicon nitride film in the source electrode pattern and the drain electrode pattern by means of a fluorine-based etching process, and deposit an ohmic metal in the regions of the source electrode pattern and the drain electrode pattern by means of a sputtering or electron beam evaporation process, so as to form the source electrode and the drain electrode.

Step S208: photolithograph a gate electrode on the uppermost barrier layer.

In the present embodiment, step S208 may specifically include: spin coat photoresist on the surface of the epitaxial substrate, photolithograph a gate root pattern of the gate electrode in a pattern arrangement direction above an epitaxial region of the P-type gallium nitride between the source electrode pattern and the drain electrode pattern, and etch the silicon nitride film in the gate electrode pattern by means of the fluorine-based etching process, so as to form a gate root profile of the gate electrode in contact with the first-type recesses and the second-type recesses; and spin coat photoresist on the surface of the epitaxial substrate, photolithograph a gate cap pattern of the gate electrode above a gate root trench of the gate electrode, deposit a gate metal in the gate cap pattern by means of electron beam evaporation, and form the gate electrode after metal lift-off process.

The gallium nitride device manufactured by means of steps S202 to S208 can enhance the linearity characteristics of a device by modulating the carrier velocity-field relationship and the gate-source capacitance under the device gate, so as to solve the problems in the related art of introduction of parasitic capacitance limiting the frequency performance, great difficulties in implementation and difficulties in large-scale application. The gallium nitride device achieves hierarchical multiplexing among multiple different conductive channels (the interfaces between the channel layers and the barrier layers), not only reducing the impact of the increasing trend of a source resistance under high source-drain current on the device linearity, but also decreasing the gate-drain reverse current leakage, improving the device breakdown performance, and achieving better device switching characteristics. Moreover, the gallium nitride device introduces minimal parasitic capacitance, is easy to implement, and is suitable for large-scale application.

In an embodiment, before step S204, the epitaxial substrate is cleaned; and a silicon dioxide layer is deposited on the surface of the epitaxial substrate to form a silicon dioxide mask layer.

In the present embodiment, step S204 may specifically include: in the case that the combination layers include a first combination layer and a second combination layer, the gate recesses include first-type recesses and second-type recesses, spin coat photoresist on the silicon dioxide mask layer, and photolithograph first-type recess patterns; etch the silicon dioxide mask layer in the first-type recess patterns by means of a fluorine-based etching process, and etch the first combination layer in the first-type recess patterns y means of a chlorine-based etching process till reaching the interior of the channel layer of the first combination layer or the interior of the barrier layer of the second combination layer, so as to form the first-type recesses; spin coat the photoresist on the surface of the epitaxial substrate, and photolithograph second-type recess patterns, wherein the second-type recess patterns and the first-type recess patterns are distributed on the same straight line at intervals; etch the silicon dioxide mask layer in the second-type recess patterns by means of the fluorine-based etching process, and etch the first combination layer and the second combination layer in the second-type recess patterns by means of the chlorine-based etching process till reaching the interior of the channel layer of the second combination layer or the interior of the buffer layer, so as to form the second-type recesses, wherein each second-type recess and the first-type recess adjacent thereto and a first layer of two-dimensional electron gas together form a first-type nano-channel, and two adjacent second-type recesses and a second layer of two-dimensional electron gas form a second-type nano-channel; and place the epitaxial substrate into MOCVD to perform a secondary growth of the P-type gallium nitride until the first-type recesses and the second-type recesses completely filled.

As the etching may cause material damage, after step S204, a weakly alkaline solution is used to repair the material damage caused by etching in the first-type recesses and the second-type recesses.

In another embodiment, after step S204, the silicon dioxide mask layer and the polycrystalline P-type gallium nitride falling on the epitaxial substrate are corroded and peeled off by means of a strong acid corrosion process, and the residual silicon dioxide mask layer is etched and removed; and passivating treatment is performed on the surface of the epitaxial substrate to generate silicon nitride film.

Further, after an ohmic metal is deposited in the regions of the source electrode pattern and the drain electrode pattern by means of a sputtering or electron beam evaporation process, so as to form the source electrode and the drain electrode, the epitaxial substrate is placed into a thermal annealing furnace for annealing treatment, so as to form an ohmic contact.

Provided in the present embodiment are a gallium nitride high linearity device with channel composite modulation based on P-N junction depletion capacitance, and a fabrication method therefor, so as to achieve the fabrication of mutually coupled nano-channels on a dual-channel material and multi-channel material, achieving hierarchical multiplexing among multiple different conductive channels, reducing the impact of the increasing trend of a source resistance under high source-drain current on the device linearity. At the same time, the gallium nitride device decreases the gate-drain reverse current leakage, improving the device breakdown performance, and achieving better device switching characteristics.

While enhancing the device linearity, the current and power output levels of the device are not sacrificed. In the present embodiment, the defect of sacrificing the current output specific to existing conventional nano-channel devices is complemented by a dual-channel (or multi-channel) material structure with dual (or multiple) layers of two-dimensional electron gas; the present embodiment enhances the off-state current leakage characteristics of the device, improves the stability and the working efficiency of the device, and achieves the purpose of energy saving and efficiency improvement in practical applications. By using the P-N junction capacitance of P-GaN/AlGaN and P-GaN/GaN, a portion of 2DEG near a P-GaN deep trench in a channel is depleted, such that the device is better turned off under an off-state gate voltage, enhancing the device breakdown performance, reducing current leakage, and improving the additional efficiency of the device under radio frequency power; the device has a wider operating gate voltage bias range, improving the efficiency of processing signals of different amplitudes. In the gate width direction, the device can be equivalent to the parallel connection form of a depletion-mode dual-channel HEMT with a Schottky metal gate structure and two proportions of P-GaN gate-enhanced devices, which can more effectively expand the transconductance operating range of the device and enhance the linearity characteristics of the device; the coupled nano-channels are formed in space, and the movement paths of charges in the device are separated out, thereby achieving the high linearity characteristics of the device. By using multiple types of nano-channels in a spatial distribution, the ratio of a source resistance to a single channel of the device is increased, reducing the surge of the source resistance of the device with the increase of channel current, enhancing the linearity characteristics of the device.

For the nano-channels fabricated in the present embodiment, as the space charge region of the P-N junctions on the side walls is gradually compressed as the gate bias voltage increases, the width of the nano-channels is gradually widened. Macroscopically, this manifests as a more linear increase in the device's current during the positive sweep of the gate voltage, thereby further enhancing the linearity of the device. It is also beneficial to make the heat source of the device evenly dispersed along with the gate voltage bias, reducing the heat dissipation pressure during operating of the device; the heat dissipation performance is better to some extent. The problem of difficulty in heat dissipation caused by current concentration of the device is evenly distributed between two types of nano-channels stacked in three dimensions.

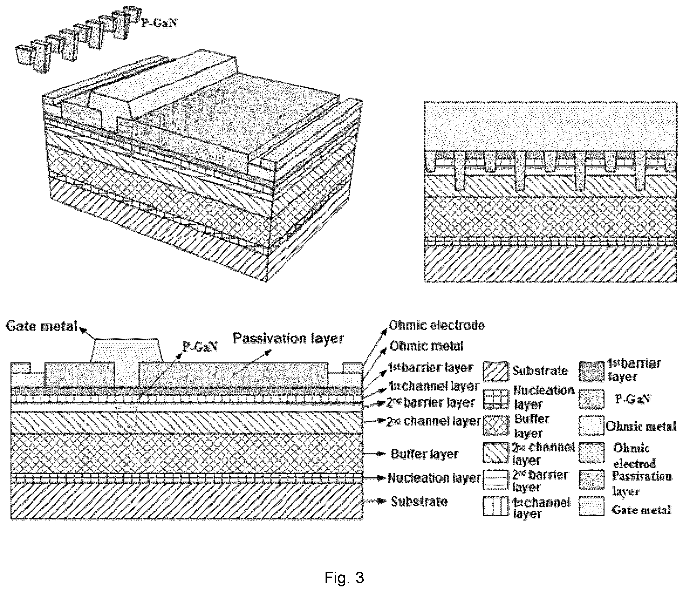

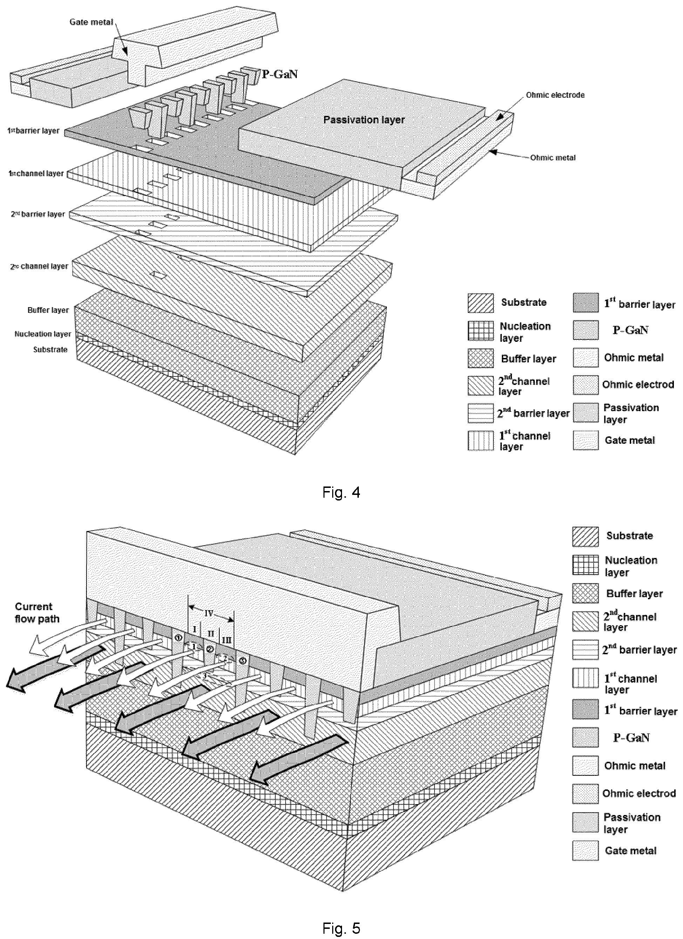

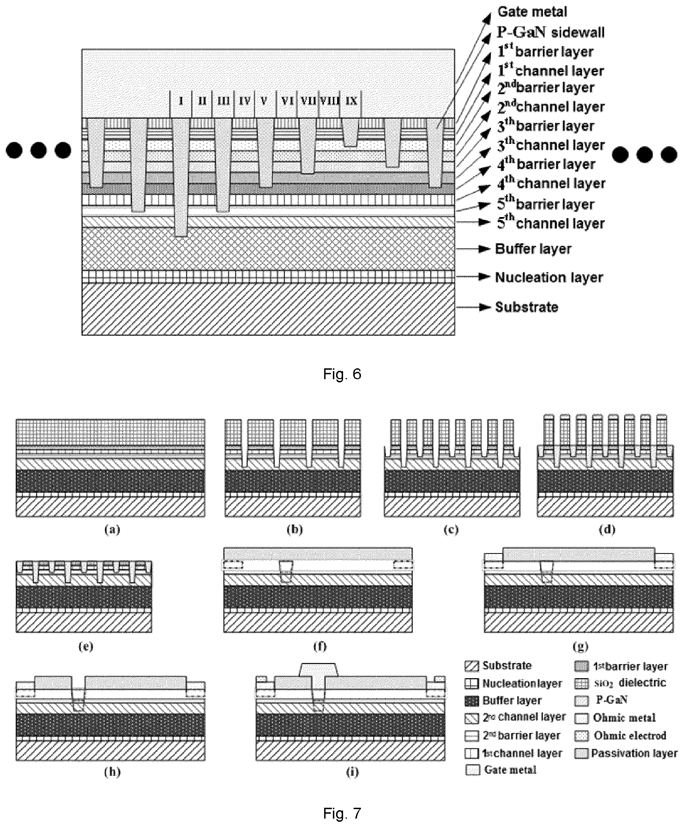

Fig. 3 is a schematic structural diagram of a gallium nitride high linearity device with channel composite modulation based on P-N junction depletion capacitance according to an embodiment of the present disclosure. As shown in Fig. 3, in the present embodiment, a P-N junction is formed on the basis of P-type doped GaN and AlGaN, and intrinsic GaN, the depletion capacitance generated thereby depletes the two-dimensional electron gas near the side walls of the device channel, thereby forming two (multiple) types of mutually coupled nano-channels on a dual-channel (multi-channel) material, enhancing the linearity characteristics of the GaN HEMT device. Thus, the linearity of the device when applied to base station amplifier modules is enhanced, so as to reduce the circuit area of a predistortion circuit module, reduce costs, and lower the difficulty in implementation, thereby enhancing the overall performance of the base station. A gallium nitride high linearity device with nano-channel modulation achieved by P-N junction depletion capacitance, including, but not limited to, from top to bottom, a substrate layer, a nucleation layer, a buffer layer, a channel layer 2, a barrier layer 2, a channel layer 1 and a barrier layer 1, wherein a gate electrode, a source electrode and a drain electrode are further arranged on the barrier layer 1. Fig. 4 is a structural exploded view of a gallium nitride high linearity device with channel composite modulation based on P-N junction depletion capacitance according to an embodiment of the present disclosure. Fig. 5 is a device-level structural exploded view of a gallium nitride high linearity device with channel composite modulation based on P-N junction depletion capacitance according to an embodiment of the present disclosure. Fig. 6 is a cross-sectional view of a GaN high linearity device with channel composite modulation based on P-N junction depletion capacitance corresponding to a five-channel material according to an embodiment of the present disclosure. As shown in Figs. 4, 5 and 6, gate recesses which are periodically distributed and mutually spaced at two depths are provided below the gate electrode, a dielectric mask growth technology is used in the recesses, and secondary growth of P-type GaN with a certain thickness is performed, such that two-dimensional electron gas (2DEG) in two layers of conductive channels are respectively depleted. Wherein the depths of the two types of recesses can respectively cut off the 2DEG at the interface between the barrier layer 1 and the channel layer 1 and the interface between the barrier layer 2 and the channel layer 2, and each deep recess and a shallow recess adjacent thereto may form a nano-channel restriction for a first layer of 2DEG at the interface between the barrier layer 1 and the channel layer 1; and two adjacent deep recesses may form a nano-channel restriction for a second layer of 2DEG at the interface between the barrier layer 2 and the channel layer 2. The two types of P-GaN recesses with different depths can be independent from each other on a spatial level of a device, uniformly divide a current flowing through the device into a three-dimensional stack structure, and reasonably and effectively perform heat distribution on the device. In addition, by means of mutual coupling between channels, a source series resistance can be modulated between two conductive channels, thereby reducing the impact of a source resistance on the linearity of a device.

The present embodiment has universality, and the barrier layer of the device is applicable to all N-group alloy barrier materials, including but not limited to GaN-based barrier materials such as AlGaN, AlInN, AIN, InAlGaN and AlScN; the channel layer of the device is applicable to all N-group alloy materials, including but not limited to GaN-based materials such as GaN, InGaN and AlGaN with a low aluminum component.

In the present embodiment, the type of dielectric serving as a dielectric mask layer for secondary growth may be SiO₂, and the growth thickness of the dielectric layer thereof is 60 nm-240 nm. As the single-crystal GaN cannot adhere to the amorphous SiO₂ during secondary epitaxial growth, SiO₂ may function as a dielectric mask. The etching process in the present embodiment should be a precision etching process, and when etching a barrier layer/channel layer of a multi-layer stack structure, the fluorine-based etching process should select a formulation of CF₄/SF₆ and O₂, the chlorine-based etching process should select a formulation of BCl₃ and Cl₂, and the self-terminated etching process for a barrier material should select a formulation of BCl₃, Cl₂ and CF₄. The etching depth of P-GaN recesses below the gate electrode should be a multiple of a multi-layer channel spacing period, and the range of the etching depth is recommended to be 40 nm-240 nm. The number of the barrier layers satisfies n ≥ 2.

Fig. 7 is a schematic diagram of a process for fabricating a GaN high linearity device with channel composite modulation based on P-N junction depletion capacitance according to an embodiment of the present disclosure. As shown in Fig. 7, the method for manufacturing a high linearity GaN-based microwave power device of the present embodiment, taking a dual-channel device as an example, includes the following steps:
step 1: an epitaxial substrate including a substrate, a nucleation layer, a buffer layer, a barrier layer 1, a channel layer 1, a barrier layer 2 and a channel layer 2 is acquired, and the epitaxial substrate is cleaned;
step 2: a SiO₂ layer is deposited on the surface of the sample by a CVD device;
step 3: photoresist is spin coatted on the SiO₂ mask layer, and first-type recess structure patterns are photolithographed;
step 4: SiO₂ in the recess patterns is etched by an ICP device by means of a fluorine-based etching process, then the barrier layer 1 and the channel layer 1 in the recess structures are etched by means of a chlorine-based etching process, and finally a self-terminated process is switched to stop the etching process at an interface between the channel layer 1 and the barrier layer 2, wherein the etching structure and a first layer of 2DEG form a first-type nano-channel;
step 5: photoresist is spin coatted on the SiO₂ mask layer, and second-type recess structure patterns are photolithographed, wherein the two types of recess patterns are distributed on the same straight line at intervals;
step 6: SiO₂ in the recess patterns is etched by the ICP device by means of the fluorine-based etching process, then the barrier layer 1, the channel layer 1, the barrier layer 2 and the channel layer 2 in the recess structures are etched by the chlorine-based etching process till reaching the interior of the channel layer 2, wherein the etching structure and a second layer of 2DEG form a second-type nano-channel, the two types of nano-channels are spatially stacked and distributed to form coupling-modulated nano-channels;
step 7: a diluted weakly alkaline solution TMAH is used to repair the material damage caused by etching in the two types of recess structures;
step 8: the sample is placed into MOCVD for secondary growth of P-type doped GaN (Mg), until P-GaN completely fills the two types of recess structures;
step 9: SiO₂ and polycrystalline P-GaN that lies above it are corroded and peeled off by means of a strong acid corrosion process, and then residual SiO₂ is etched away by the ICP device;
step 10: passivating treatment is performed on the surface of the sample by means of LPCVD, PECVD or ALD process for depositing to generate a SiN (Al2O₃/SiO₂) film;
step 11: photoresist is spin coatted on the surface of the sample, source and drain electrode patterns are photolithographed, and a predetermined dose of Si ion implantation is performed on the source and drain electrodes by means of an ion-Beam injection process;
step 12: photoresist is spin coatted on the surface of the sample, the source and drain electrode patterns are photolithographed again, SiN in the source and drain electrode patterns is etched by means of the ICP fluorine-based etching process, and an ohmic metal is deposited in the regions of the source and drain electrode patterns by means of a sputtering or electron beam evaporation process;
step 13: the sample is placed into a rapid thermal annealing furnace for low-temperature annealing treatment, so as to form an ohmic contact;
step 14: photoresist is spin coatted on the surface of the sample, a gate electrode pattern is photolithographed above a P-GaN secondary epitaxial region between the source and drain electrode patterns, and a SiN passivation layer in the gate electrode region is etched by the ICP device by means of the fluorine-based etching process, so as to form gate recess structures;
step 15: a gate metal is deposited above the gate recesses by means of electron beam evaporation, and metal lift-off process is performed to form the gate electrode; interconnection opening and interconnection metal processes are completed to finish device fabrication.

Obviously, those skilled in the art should understand that various modules or various steps in the embodiments of the present disclosure can be implemented by a universal computing apparatus, and the various modules or steps can be integrated on a single computing apparatus or distributed over a network formed by a plurality of computing apparatuses, and can be implemented by program codes executable by the computing apparatus, such that the modules or steps can be stored in a storage apparatus and executed by the computing apparatus, and the shown or the steps can be executed in sequences different from those described here in some cases, or the various modules or steps can be implemented by manufacturing the modules or steps into various integrated circuit modules respectively, or manufacturing multiple modules or steps among the various modules or steps into a single integrated circuit module. Thus, the present disclosure is not limited to any particular combination of hardware and software.

The foregoing descriptions are merely preferred embodiments of the present disclosure, and are not intended to limit the present disclosure. For those skilled in the art, the present disclosure may have various modifications and variations. Any modifications, equivalent replacements, improvements and the like made within the principle of the present disclosure shall belong to the scope of protection of the present disclosure.

## Claims

1. A gallium nitride device, comprising: at least two combination layers, wherein a gate electrode is arranged on the uppermost combination layer; a plurality of gate recesses having different depths are provided below the gate electrode, and the gate recesses are filled with P-type gallium nitride.

2. The gallium nitride device according to claim 1, wherein the plurality of gate recesses are distributed periodically below the gate electrode.

3. The gallium nitride device according to claim 1, wherein the P-type gallium nitride is filled in the gate recesses by means of a dielectric mask growth technology.

4. The gallium nitride device according to claim 1, wherein each combination layer comprises a channel layer and a barrier layer which are connected from bottom to top, and the P-type gallium nitride is used for depleting a two-dimensional electron gas at an interface between the barrier layer and the channel layer in each combination layer corresponding to the gate recesses.

5. The gallium nitride device according to claim 4, wherein the gallium nitride device further comprises: a substrate layer, a nucleation layer and a buffer layer which are connected from bottom to top, wherein the buffer layer is connected to the at least two combination layers from bottom to top.

6. The gallium nitride device according to claim 5, wherein
the number of gate recess types is the same as that of the combination layers, different types of gate recesses have different depths, and the different types of gate recesses are used for cutting off the two-dimensional electron gas in different combination layers.

7. The gallium nitride device according to claim 6, wherein
in the case that the combination layers comprise a first combination layer and a second combination layer, the gate recesses comprise first-type recesses and second-type recesses, the first-type recesses extend into the channel layer of the first combination layer or into the barrier layer of the second combination layer, and the second-type recesses extend into the channel layer of the second combination layer or into the buffer layer, wherein the first-type recesses are used for cutting off the two-dimensional electron gas at the interface between the barrier layer and the channel layer in the first combination layer; and the second-type recesses are used for cutting off the two-dimensional electron gas at the interface between the barrier layer and the channel layer in the first combination layer, and the interface between the barrier layer and the channel layer in the second combination layer.

8. The gallium nitride device according to claim 7, wherein
each first-type recess and the second-type recess adjacent thereto form a nano-channel restriction for a first layer of the two-dimensional electron gas at the interface between the barrier layer and the channel layer in the first combination layer; and
the second-type recesses which are adjacent to each other form a nano-channel restriction for a second layer of two-dimensional electron gas at the interface between the barrier layer and the channel layer in the second combination layer.

9. The gallium nitride device according to any of claims 1 to 8, wherein
the number of gate recess types is the same as that of the combination layers.

10. The gallium nitride device according to any of claims 1 to 8, wherein
the depths of the gate recesses range from 40 nm to 240 nm.

11. A method for manufacturing a gallium nitride device, comprising:
acquiring an epitaxial substrate comprising at least two combination layers;
etching to fabricate a plurality of gate recesses having at least two depths in the at least two combination layers;
filling the gate recesses with P-type gallium nitride; and
fabricating a gate electrode on the uppermost combination layer.

12. The method according to claim 11, wherein the epitaxial substrate further comprises: a substrate layer, a nucleation layer and a buffer layer which are connected from bottom to top, wherein the buffer layer is connected to the at least two combination layers from bottom to top.

13. The method according to claim 12, wherein the plurality of gate recesses having at least two depths are distributed periodically below the gate electrode, the number of gate recess types is the same as that the combination layers, different types of gate recesses have different depths, and the different types of gate recesses are used for cutting off a two-dimensional electron gas in different combination layers.

14. The method according to claim 13, wherein each combination layer comprises a channel layer and a barrier layer which are connected from bottom to top.

15. The method according to claim 14, wherein in the case that the combination layers comprise a first combination layer and a second combination layer, the gate recesses comprise first-type recesses and second-type recesses; each second-type recess and the first-type recess adjacent thereto and a first layer of two-dimensional electron gas together form a first-type nano-channel, and two adjacent second-type recesses and a second layer of two-dimensional electron gas form a second-type nano-channel.

16. The method according to claim 15, wherein etching to fabricate a plurality of gate recesses having at least two depths in the at least two combination layers comprises:
spin coating photoresist on the surface of the epitaxial substrate, and photolithographing first-type recess patterns;
etching the first combination layer in the first-type recess patterns to form the first-type recesses;
spin coating photoresist on the surface of the epitaxial substrate, and photolithographing second-type recess patterns, wherein the second-type recess patterns and the first-type recess patterns are distributed on the same straight line at intervals; and
etching the first combination layer and the second combination layer in the second-type recess patterns to form the second-type recesses.

17. The method according to claim 16, wherein etching the first combination layer in the first-type recess patterns to form the first-type recesses comprises:
etching the first combination layer in the first-type recess patterns by means of a fluorine-based etching process, stopping within the channel layer of the first combination layer or within the barrier layer of the second combination layer to form the first-type recesses.

18. The method according to claim 17, wherein etching the first combination layer and the second combination layer in the second-type recess patterns to form the second-type recesses comprises:
etching the first combination layer and the second combination layer in the second-type recess patterns by means of the fluorine-based etching process, stopping within the channel layer of the second combination layer or within the buffer layer to form the second-type recesses.

19. The method according to claim 18, wherein filling the gate recesses with P-type gallium nitride comprises:
filling the gate recesses with a pre-determined thickness of P-type gallium nitride by means of a dielectric mask growth technology; and
placing the epitaxial substrate into MOCVD to perform a secondary growth of the P-type gallium nitride until the first-type recesses and the second-type recesses completely filled.

20. The method according to claim 15, wherein fabricating a gate electrode on the uppermost combination layer comprises:
spin coating the photoresist on the surface of the epitaxial substrate, photolithographing a gate root pattern of the gate electrode in a pattern arrangement direction above an epitaxial region of the P-type gallium nitride between a source electrode pattern and a drain electrode pattern, and etching silicon nitride film in a gate electrode pattern by means of a fluorine-based etching process, to form a gate root profile of the gate electrode in contact with the first-type recesses and the second-type recesses; and
spin coating the photoresist on the surface of the epitaxial substrate, photolithographing a gate cap pattern of the gate electrode above a gate root trench of the gate electrode, depositing gate metal in the gate cap pattern by means of electron beam evaporation, and forming the gate electrode after metal lift-off process.

21. The method according to claim 15, wherein before etching to fabricate a plurality of gate recesses having at least two depths in the at least two combination layers, the method further comprises:
cleaning the epitaxy substrate; and
depositing a silicon dioxide layer on the surface of the epitaxial substrate to form a silicon dioxide mask layer.

22. The method according to claim 21, wherein after etching to fabricate a plurality of gate recesses having at least two depths in the at least two combination layers, the method further comprises: repairing material damage caused by etching in the first-type recesses and the second-type recesses using a weakly alkaline solution.

23. The method according to claim 22, wherein after filling the gate recesses with a pre-determined thickness of P-type gallium nitride, the method further comprises:
corroding and peeling off the silicon dioxide mask layer and the polycrystalline P-type gallium nitride falling on the epitaxial substrate by means of a strong acid corrosion process, and etching and removing the residual silicon dioxide mask layer; and
performing passivating treatment on the surface of the epitaxial substrate to generate silicon nitride film.

24. The method according to claim 14, wherein before fabricating a gate electrode on the uppermost combination layer, the method further comprises: fabricating a source electrode and a drain electrode on the uppermost combination layer.

25. The method according to claim 24, wherein fabricating a source electrode and a drain electrode on the uppermost combination layer comprises:
spin coating the photoresist on the surface of the epitaxial substrate, photolithographing a source electrode pattern and a drain electrode pattern, and performing a predetermined dose of silicon ion implantation into the source electrode pattern and the drain electrode pattern by means of an ion implantation process; and
spin coating the photoresist on the surface of the epitaxial substrate, photolithographing the source electrode pattern and the drain electrode pattern again, etching silicon nitride film in the source electrode pattern and the drain electrode pattern by means of a fluorine-based etching process, and depositing an ohmic metal in the regions of the source electrode pattern and the drain electrode pattern by means of a sputtering or electron beam evaporation process, to form the source electrode and the drain electrode.

26. The method according to claim 25, wherein after depositing an ohmic metal in the regions of the source electrode pattern and the drain electrode pattern by means of a sputtering or electron beam evaporation process, form the source electrode and the drain electrode, the method further comprises:
placing the epitaxial substrate into a thermal annealing furnace for annealing treatment, to form an ohmic contact.
